# EUROPEAN PATENT APPLICATION

(11) **EP 4 804 398 A1**
(43) Date of publication of application: **09.09.2026**
(21) Application number: 26159554.0
(22) Date of filing: 19.02.2026
(51) Int. Cl.: H02P 6/28

(54) **A METHOD AND CIRCUIT ARRANGEMENT FOR DETERMINING A RESISTANCE**

(30) Priority: 04.03.2025 US 202519070226
(71) Applicant: Analog Devices International Unlimited Company, Limerick (IE)
(72) Inventor: DWERSTEG, Bernhard Karl-Heinz, Co. Limerick (IE)
(74) Representative: Yang, Shu

(57) **Abstract**

A new method and circuit arrangement for determining a resistance of a first drive transistor in a drive system for operating a motor. The drive system comprising a first drive transistor, a first sense transistor, and a second drive transistor. The first sense transistor is arranged in parallel with the first drive transistor. Each transistor comprising a control terminal, a first channel terminal, and a second channel terminal. The first and second drive transistors are switched to operate the motor using an operating current. The first sense transistor is operated to determine the on-state resistance of the first drive transistor. The operating current flows between motor coils of the motor and the reference node through the first sense transistor.

## Description

### FIELD

This application relates to methods and circuit arrangements for determining a resistance of a first drive transistor. Specifically, for determining a resistance of a first drive transistor in a motor drive system during the operation of a motor.

### BACKGROUND

It is generally known that in BLDC / PMSM motor drives using the FOC control scheme (with sensors, or sensorless), allows highest efficiency by applying a sine wave shaped current waveform to the stator fitting to the actual state the motor is in. Similar requirements are used for operating stepper motors. Even small BLDC/PMSM motors, for example, those in power tools often need higher drive current than directly possible from a smart-power IC. Therefore a 6 MOSFET inverter stage is standard in many applications, including BLDC / PMSM motor drives (or a 4 or 8 MOSFET inverter in the case of a stepper motor). The MOSFETs in turn are driven by a gate-driver IC. For FOC drive, a precise knowledge of the motor currents is mandatory and a main task of the electronics design.

Current sensing in external MOSFET bridges typically requires expensive and bulky sense resistors. Further, these have a high power dissipation, similar to the MOSFETs themselves. In-line current sensing is most universal and typically needs only two resistors per three-phase motor, but the required high-common mode range sense amplifiers are complex and expensive. Further, current continuously passes the resistors and in many cases doubles the output resistance of the circuit.

An alternative is magnetic field based current sensing. It has a low power dissipation, but also requires expensive sensors. Foot-point current sensing gives similar results to in-line sensing as long as the PWM scheme offers sufficiently long on-times of the low side for at least two of the three foot-points. This typically is the case with many PWM schemes. Foot-point sensing requires measurement in each foot-point, i.e. three high-current and high-power sense resistors. Single shunt footpoint measurement is an option used for cost-reduction, but it is complex and hard to handle, as it causes a number of restrictions and modifications to the PWM scheme in order to yield sufficient measuring time intervals for each phase.

There is a need for an inexpensive, reliable, and accurate method for current sensing in transistor-based motor control circuits.

### SUMMARY OF THE DISCLOSURE

According to a first aspect there is provided a method of determining a resistance of a first drive transistor in a drive system for operating a motor, the drive system comprising a first drive transistor, a first sense transistor, and a second drive transistor, wherein the first sense transistor is arranged in parallel with the first drive transistor, each transistor comprising a control terminal, a first channel terminal, and a second channel terminal,
the method comprising:
   switching the first and second drive transistors to operate the motor using an operating current, wherein current is configured to flow between the first and second channel terminals of each drive transistor in an on-state such that the operating current flows between motor coils of the motor and a reference node, and wherein the reference node is shared by each of the transistors; and
operating the first sense transistor to determine the on-state resistance of the first drive transistor, wherein the operating current flows between motor coils of the motor and the reference node through the first sense transistor.

Optionally, the drive system further comprises a second sense transistor corresponding to the second drive transistors and arranged in parallel with the second drive transistor. Optionally, the method further comprising: operating the second sense transistor to determine the on-state resistance of the first drive transistor. Optionally, the operating current flows between motor coils of the motor and the reference node through the second sense transistor.

Optionally, the on-state resistance of the first drive transistor is determined based on determining a current flowing through each of the first and second sense transistors.

Optionally, the method further comprises: determining the motor current based on a measured voltage and the on-resistance of the first drive transistor.

Optionally, operating the first and second sense transistors comprises: operating the first sense transistor in an on-state when the first drive transistor is commanded to operate in an on-state.

Optionally, operating the first and second sense transistors comprises: operating the first sense transistor in an on-state when the second drive transistor is commanded to operate in the on-state.

Optionally, when the first sense transistor is operated in the on-state and the first drive transistor is commanded to operate in the on-state, operating the first drive transistor in an off-state for a first time period. Optionally, when the first sense transistor is operated in the on-state and the first drive transistor is commanded to operate in the on-state, measuring a current flowing through the first sense transistor during the first time period. Optionally, when the first sense transistor is operated in the on-state and the first drive transistor is commanded to operate in the on-state, measuring a voltage difference between the first and second channel terminals of the second drive transistor during the first time period.

Optionally, the method further comprising: during a first time period, operating the first drive transistor in the on-state; and, measuring a first voltage difference between the first and second channel terminals of the first drive transistor. Optionally, the method further comprising during a second time period, operating the first drive transistor in the on-state; measuring a second voltage difference between the first and second channel terminals of the first drive transistor; and, operating the first sense transistor in on-state during the second time period. Optionally, the method further comprising: during a third time period, operating the first drive transistor in the on-state; and, measuring a third voltage difference between the first and second channel terminals of the first drive transistor. Optionally, determining the on-state resistance of the first drive transistor is based on the measured first, second, and third voltage differences.

Optionally, the method further comprising during the first time period, operating the first sense transistor in the off-state. Optionally, the first sense transistor is operated in the on-state during the second time period. Optionally, the method further comprising during the third time period, operating the first sense transistor in the off-state.

Optionally, the method further comprising operating each of the first and second drive transistors in the on-state continuously during the first and second time periods.

Optionally, operating the first and second sense transistors comprises: operating the second sense transistor in an on-state when the second drive transistor is commanded to operate in an on-state.

Optionally, the second sense transistor is operated in an on-state when the first and second drive transistors are commanded to operate in the on-state.

Optionally, when the second sense transistor is operated in the on-state and the second drive transistor is commanded to operate in the on-state: operating the second drive transistor in an off-state for a second time period; measuring a current flowing through the second sense transistor during the second time period; and measuring a voltage difference between the first and second channel terminals of the first drive transistor during the second time period.

Optionally, the method further comprising during a fourth time period, operating the second drive transistor in the on-state; and, measuring the fourth voltage difference between the first and second channel terminals of the second drive transistor. Optionally, the method further comprising during a fifth time period, operating the second drive transistor in the on-state; and, measuring a fifth voltage difference between the first and second channel terminals of the second drive transistor. Optionally, the method further comprising during a sixth time period, operating the second drive transistor in the on-state; and, measuring a sixth voltage difference between the first and second channel terminals of the second drive transistor. Optionally, determining the on-state resistance of the first drive transistor is based on the measured fourth, fifth, and sixth voltage differences.

Optionally, the method further comprising during the fourth time period, operating the second sense transistor in the off-state, wherein the second sense transistor is operated in the on-state during the fifth time period. Optionally, the method further comprising during the sixth time period, operating the second sense transistor in the off-state.

Optionally, the method further comprising comparing a voltage difference between the first and second channel terminals of the first drive transistor to a first sense transistor limitation threshold. Optionally, when the voltage difference is less than the first sense transistor limitation threshold, operating the first sense transistor in the on-state.

Optionally, when the voltage difference is less than the first sense transistor limitation threshold, operating the first drive transistor in the off-state.

Optionally, the first sense transistor limitation threshold is less than the amplitude of the operating current.

According to a second aspect there is provided a method of determining a motor current based on an applied voltage and an on-resistance of the first drive transistor, wherein the on-resistance of the first drive transistor is determined by the method of the first aspect.

According to a third aspect there is provided a method of operating a motor based on a motor current determined by the method of the second aspect.

According to a fourth aspect there is provided a driver circuit comprising:
first and second drive transistors and corresponding first and second sense transistors, wherein each sense transistor is arranged in parallel with a respective one of the drive transistors, the first and second drive transistors arranged to drive a load, each transistor comprising a control terminal, a first channel terminal, and a second channel terminal, wherein current is configured to flow between the channel terminals of each drive transistor in an on-state such that an operating current flows between motor coils of the motor and a reference node, wherein the reference node is shared by each of the transistors; and
one or more processors configured to perform the method of the first aspect.

Optionally, further comprising a logic circuit configured to receive a command signal configured to operate the first drive transistor, wherein the command signal is generated by the one or more processors for PWM control of the motor. Optionally, further comprising a logic circuit configured to receive an override signal based on the on-state and/or off-state of each of the drive transistors. Optionally, further comprising a logic circuit configured to operate the first drive transistor based on the command signal and the override signal.

Optionally, the override signal is further based on: the voltage difference between the first and second channel terminals of the first drive transistor; and, a first sense transistor limitation threshold.

Optionally, the one or more processors comprise a gate driver integrated circuit, and the gate driver integrated circuit comprises the sense transistors. Optionally, the drive transistors are external to the one or more processors.

Optionally, the first sense transistor has a greater on-resistance than the first drive transistor.

### FIGURES

Figure 1a illustrates a schematic block wiring diagram of a driver circuit coupled to a motor.
Figure 1b illustrates a simplified representation of the block wiring diagram of the driver circuit coupled to the motor of Figure 1a.
Figure 2 illustrates a schematic block wiring diagram of a driver circuit coupled to a motor with additional optional features.
Figure 3 illustrates three graphs corresponding to the command signal of each drive transistors of Figure 2, one graph corresponding to a control signal of one of the drive transistors of Figure 2, and one graph corresponding to control signal of a sense transistor of Figure 2 in accordance with a first method of determining a resistance of a first drive transistor in a drive system.
Figure 4 illustrates three graphs each corresponding to a control signal of each drive transistor of Figure 2 and three graphs each corresponding to the control signal of each sense transistor in accordance with a first method of determining a resistance of a first drive transistor in a drive system.
Figure 5a illustrates a schematic block wiring diagram of a driver circuit configured to drive one phase of a motor with additional optional features.
Figure 5b illustrates a graph of the current in each motor coil over time.
Figure 6 illustrates three graphs each corresponding to a control signal of each drive transistor of Figure 2 and three graphs each corresponding to the control signal of each sense transistor in accordance with a second method of determining a resistance of a first drive transistor in a drive system.
Figure 7 illustrates four graphs corresponding to one period of time *tₐ* of Figure 6 in accordance with a second method of determining a resistance of a first drive transistor in a drive system.
Figure 8 illustrates a graph representing the change in voltage between an initial time period and a second time period corresponding to one phase of the motor.
Figure 9 illustrates three graphs corresponding to the control signal of each drive transistor of Figure 2 and one graph corresponding to the control signal of each sense transistor in accordance with a variation of the second method of determining a resistance of a first drive transistor in a drive system.
Figure 10 illustrates three graphs corresponding to the command signal of each drive transistors of Figure 2, and two graphs corresponding to a control signal of one of the drive transistors of Figure 2, and one sense transistor of Figure 2, in accordance with a third method of determining a resistance of a first drive transistor in a drive system.
Figure 11 illustrates a graph representing the change in voltage between an initial time period and a second time period corresponding to one phase of the motor.
Figure 12 illustrates a schematic block wiring diagram of a driver circuit coupled to one coil of a stepper motor.

### DETAILED DESCRIPTION

As a brief non-limiting overview of the invention, the present disclosure provides a method of determining a resistance of a drive transistor of a transistor-based driver circuit. With this resistance determined, a new method of current sensing/estimating in motor control circuits may be achieved which is advantageous in view of existing solutions. The method of determining a resistance of a drive transistor of a transistor-based driver circuit may be utilized with existing transistor driver control schemes. Specifically, during an on-state of the drive transistor during regular operation of a motor (by existing transistor driver control schemes), at least partially diverting the current from passing through a drive transistor to a sense transistor (e.g., a smaller and lower power rated transistor than the drive transistor) to determine the on-state resistance of the drive transistor. Advantageously, this method may make use of current sense amplifiers as simple as those suitable for use with footpoint-shunt resistor amplifiers.

On-state resistance based current measurement has not been adopted previously because transistor (e.g., MOSFET) on-state resistance is highly dependent on production stray and changes with transistor (e.g., MOSFET) die temperature, especially in applications with high current. Therefore, quick recalibration of the on-state resistance measurement is required, as the temperature of the die can change within milliseconds. Thus, a problem overcome with the present disclosure is a method for calibration to compensate for transistor (e.g., MOSFET) stray and the temperature dependence of resistance.

Advantageously, embodiments of the invention achieve an accurate and cost-effective solution: an extension circuit of the gate driver (e.g., realized in a HV-Power BCD technology) with means for on-state resistance calibration, with a corresponding algorithm. Power dissipation is low compared to a known sense-resistor based measurement, because current is diverted away from the drive transistor to pass through the sense-transistor for only a short period of time. Therefore, the sense transistor may be a low power-rated device.

In the following examples, a three-phase drive system with three connections (corresponding with phases u, v, and w) is described. However, it will be understood that the principles may apply to any number phased motor drive system. For example, stepper motors have four connections and are typically driven with two coils. It will be readily apparent to a skilled person how to translate the examples provided to other phased motors, including stepper motors. In addition, the principles may apply to any load driven by transistors operating in a scheme of switching (e.g., a PWM switching scheme).

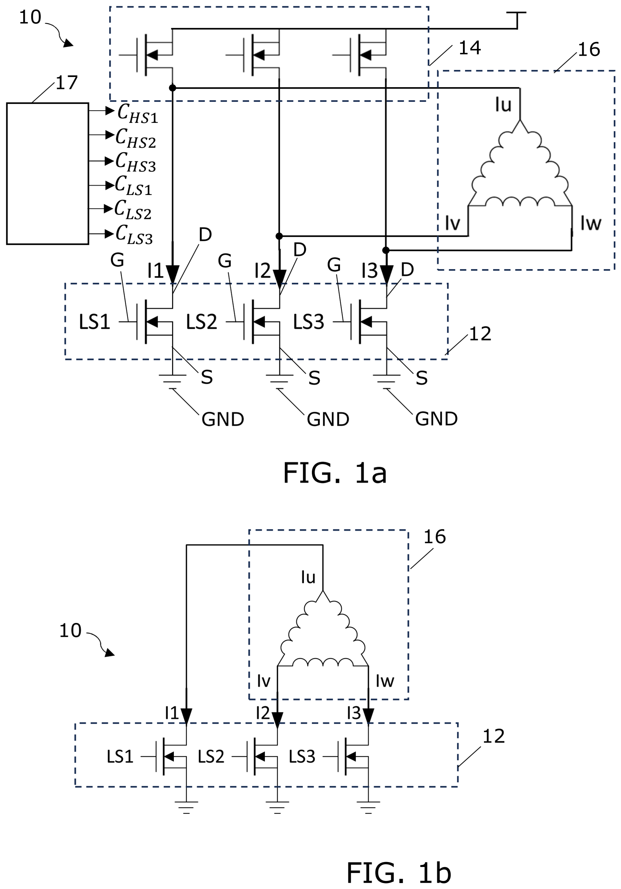

Figure 1a shows an example of a schematic block wiring diagram of a driver circuit 10 (such as a motor driver circuit) coupled (in electrical communication) to a motor 16 for carrying out the method in accordance with the invention. The driver circuit 10 comprises a first plurality of transistors 12, e.g., Low Side (LS) transistors, each corresponding to a phase of the motor 16, e.g., drive transistor LS1 corresponds to a u-phase, drive transistor LS2 corresponds to a v-phase, drive transistor LS3 corresponds to a w-phase. The driver circuit 10 comprises a second plurality of transistors 14, e.g., High Side (HS) transistors, each corresponding to a phase of the motor 16. Each transistor of the driver circuit 10 comprises a control terminal (e.g., Gate, G), a first channel terminal (e.g., Drain, D), and a second channel terminal (e.g., Source, S). Each transistor of the driver circuit 10 is also arranged to be in an on-state or an off-state.

In operation, a controller 17 switches the plurality of transistors to operate the motor 16 using an operating current. Current is configured to flow between the first and second channel terminals D, S of each transistor in an on-state such that the operating current flows between motor coils of the motor 16 and a reference node GND. The reference node GND is shared by the first plurality of transistors 12.

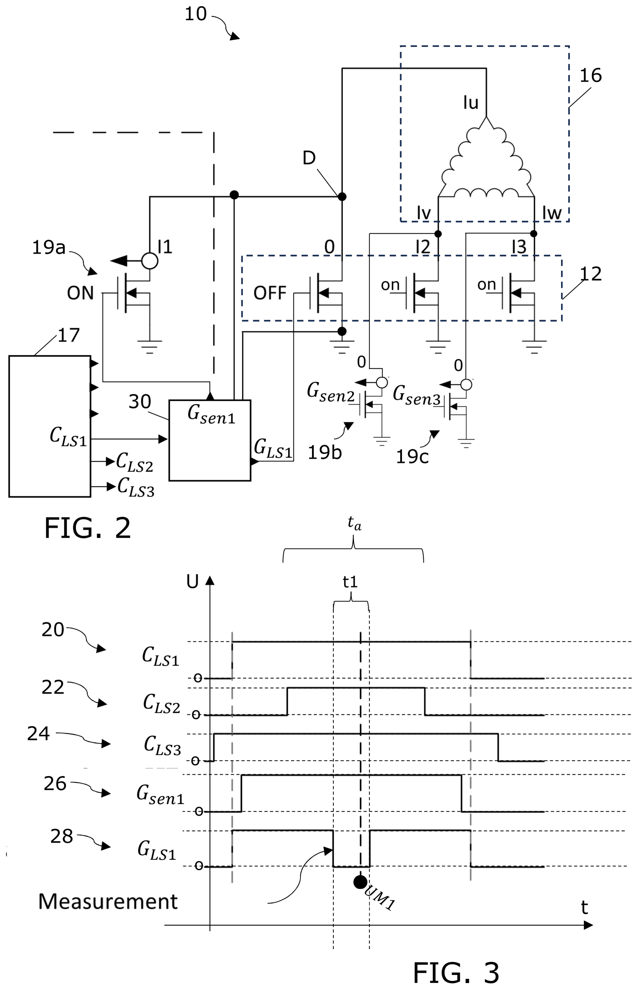

For purposes of explanation, only one of the first or second plurality of transistors 12, 14 are required. Figure 1b shows a simplified schematic block wiring diagram of a driver circuit 10 with only the first plurality of transistors 12 shown. However, it will be understood that the second plurality of transistors 14 are still present in the circuit, but not shown in Figure 1b for simplicity. The second plurality of transistors 14 are also similarly omitted from the examples corresponding with Figure 2, however, it will be understood that the second plurality of transistors 14 are still present in this circuit, but not shown for simplicity. Alternatively, the second plurality of transistors 14 could have been shown and described, and the first plurality of transistor 12 could have been omitted for explanatory purposes.

It will be described with reference to Figures 2 to 12, that the on-resistance of a first drive transistor LS1 is determined by switching the first and second drive transistors to operate the motor 16 using an operating current. Current is configured to flow between the first and second channel terminals of each drive transistor in an on-state such that the operating current flows between motor coils of the motor 16 and a reference node GND The reference node GND is shared by each of the transistors (e.g., at least LS1, LS2, and a first sense transistor). The first sense transistor is operated to determine the on-state resistance of the first drive transistor LS1. The operating current flows between motor coils of the motor and the reference node through the first sense transistor.

Figure 2 shows a schematic block wiring diagram of the driver circuit 10 with additional optional features for carrying out the method in accordance with the invention. The driver circuit 10 may comprise controller 17 to send command signals to the first and second plurality of transistors 12, 14. The driver circuit 10 may further comprise a first sense circuit 30 arranged to receive a first command signal *C*_{*LS*1} for a first drive transistor LS1 of the first plurality of transistors 12 from the controller 17, and generate control signals for the first drive transistor LS1 and a first sense transistor 19a. The driver circuit 10 may comprise a further sense circuits (similar to the first sense circuit 30) and sense transistors 19b, 19c (similar to the sense transistor 19a) for each transistor LS1, LS2, LS3 of the first plurality of transistors 12 (i.e., corresponding to each phase of the motor 16), respectively. A first channel terminal D of each controllable sense transistor 19a, 19b, 19c is in electrical communication with a first channel terminal D of a corresponding one of the first plurality of transistors 12 (and also in electrical communication with a corresponding phase connection of the motor 16). The reference node GND may be shared by each second channel terminal S of the sense transistors. Each sense transistor 19a, 19b, 19c is configured to be in an on-state or an off-state. Each sense transistor is arranged in parallel with a corresponding drive transistor of the first plurality of transistors 12. In an alternative example, the driver circuit 10 may comprise only a single sense transistor 19a, for example, in parallel with one of the first plurality of transistors 12.

The controller 17 (e.g., one or more processors) may be a gate driver integrated circuit. The gate driver integrated circuit may comprise the sense circuits (e.g., sense circuit 30) and the sense transistors (e.g., sense transistor 19a). The drive transistors are external to the controller 17.

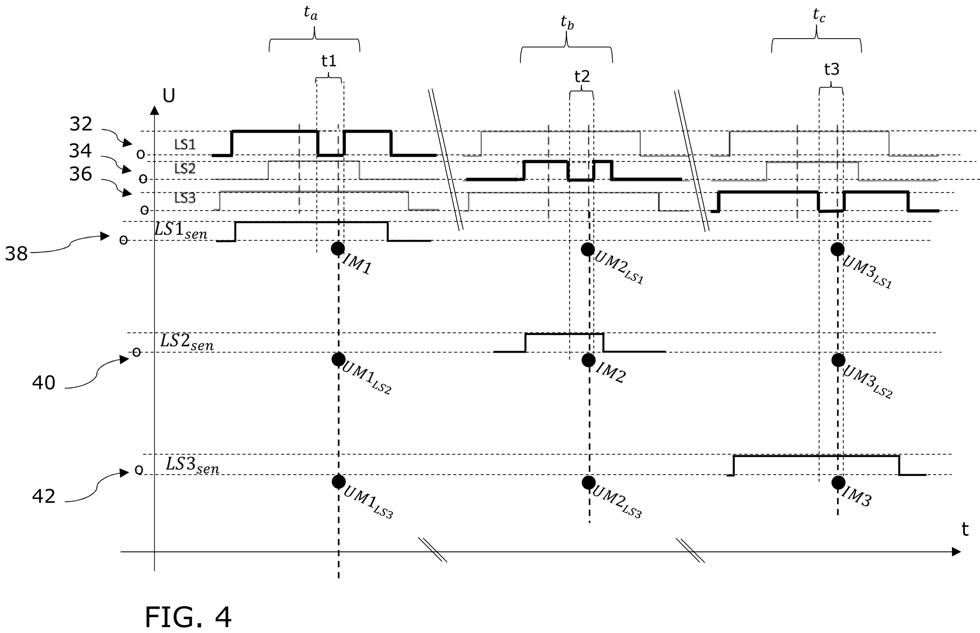

A first method of determining an on-state resistance of a first drive transistor in a drive system for operating a motor 16 is described with reference to Figures 3 and 4.

Figure 3 shows graphs 20, 22, 24 corresponding to the command signal (e.g., a PWM signal generated in accordance with a drive transistor control scheme) of each drive transistor LS1, LS2, LS3 of the first plurality of transistors 12 generated by controller 17. The graph 20 corresponds to a first drive transistor LS1 and shows part of a pulse width modulation (PWM) signal such that during time period t1 the first drive transistor LS1 is commanded to operate in its on-state. The graph 22 corresponds to a second drive transistor LS2 and shows part of a PWM signal such that during time period t1 the second drive transistor LS2 is in its on-state. The graph 24 corresponds to a third drive transistor LS3 and shows part of a PWM signal such that during time period t1 the third drive transistor LS3 is in its on-state. The graph 26 corresponds to a first sense transistor 19a and shows part of a control signal *G*_{*sen*1} such that during time period t1 the first sense transistor 19a is in its on-state. The graph 28 corresponds to a first drive transistor LS1 and shows part of a control signal *G*_{*LS*1} such that during time period t1 the first sense transistor 19a is in its off-state, contrary to its command signal *C*_{*LS*1} shown in graph 20 (as a result of first sense circuit 30).

This arrangement diverts the current intended to flow through the first drive transistor LS1 (from the motor coils to the reference node) into the first sense transistor 19a for the first time period t1. The first sense transistor 19a may operate in its on-state and the first drive transistor LS1 may operate in its off-state when each of the first plurality of transistors 12 are commanded (by the PWM signal generated by the controller 17) to simultaneously operate in their respective on-state, i.e., during a period of time *tₐ.*

PWM schemes (e.g., for three-phase motor control) may include times, where all of the first plurality of transistors 12 (i.e., all low-side switches) are commanded to be in their respective on-state. These recirculation times may occur in low velocity motion, where effective PWM duty cycle is small, but may also repeatedly occur in generation of sine-shaped commutation control signals, e.g. when using a centred PWM scheme. Whenever such a period of time *tₐ* (when all of the first plurality of transistors are in their on-state) occurs, a determination (e.g., a calibration or recalibration) of one or more on-state resistances of the first plurality of transistors 12 may be performed.

Graphs 26 and 28 illustrate the control signals that allow current I1 to flow through the first sense transistor 19a (*LS*1*ₛₑₙ*) during the time period t1, due to the first sense transistor 19a operating in an on-state and first drive transistor LS1 operating in an off-state during the time period t1. The current I1 flowing through the first sense transistor 19a may be measured by the driver circuit 10 (e.g., a BCD-MOS gate driver IC) using integrated current sensing means, or by a sense resistor.

In an example, the first sense transistor 19a is a lower power-rated transistor than the first drive transistor LS1 and has a larger internal on-resistance. Due to measurement noise and measurement offsets, a larger current may increase the accuracy of a current I1 measurement. In an example, the first sense transistor 19a may be manufactured with a known on-resistance.

The method may include making a voltage difference measurements UM1 between the first and second channel terminals of the remaining first plurality of transistors 12 (i.e., the second drive transistor LS2, and the third drive transistor LS3, in Figure 2) during the first time period t1. In some examples, a certain voltage drop over the second and third transistors LS2, LS3 is required to give sufficient signal amplitude for measurement.

The time period t1 may at least cover the minimum required time to perform the voltage difference measurement UM1 (e.g. 2µs, 5µs, 10µs). The time period t1 may at least also cover the minimum time required to perform the current I1 measurement. To determine the current I1 measurement, the drive transistor may be switched off for a sufficient time to allow the sense transistor to see the full current and to correctly measure it.

In an example, the drive system comprises a second sense transistor 19b (*LS*2*ₛₑₙ*) corresponding to the second drive transistors LS2 and arranged in parallel with the second drive transistor LS2. The second sense transistor 19b may be operated to determine the on-state resistance of the first drive transistor LS1. When the second sense transistor 19b is in an on-state, the operating current flows between motor coils of the motor 16 and the reference node through the second sense transistor 19b. In a 3-phase motor system, the drive system comprises a third sense transistor 19c (*LS*3*ₛₑₙ*) corresponding to the third drive transistors LS3 and arranged in parallel with the third drive transistor LS3. The third sense transistor 19c may be operated to determine the on-state resistance of the first drive transistor LS1. When the third sense transistor 19c is in an on-state, the operating current flows between motor coils of the motor 16 and the reference node through the third sense transistor 19c.

As shown in Figure 4, each transistor of the first plurality of transistors 12 (LS1, LS2, LS3) corresponds to one sense transistor 19a, 19b, 19c (*LS*1*ₛₑₙ*, *LS*2*ₛₑₙ*, *LS*3*ₛₑₙ*). During each time period t1, t2, t3 a drive transistor LS1, LS2, LS3 is operated in the off-state and a corresponding sense transistor 19a, 19b, 19c (*LS*1*ₛₑₙ*, *LS*2*ₛₑₙ*, *LS*3*ₛₑₙ*) is operated in its on-state. One drive transistor LS1, LS2, LS3 is operated in its off-state at a time. One current measurement is measured at a time, corresponding to one sense transistor 19a, 19b, 19c (*LS*1*ₛₑₙ*, *LS*2*ₛₑₙ*, *LS*3*ₛₑₙ*) operating in its on-state The first period of time *tₐ* comprises time period t1. The second period of time *t_{b}* comprises time period t2. The third period of time *t_{c}* comprises time period t3. Each of the first plurality of transistors 12 are commanded to simultaneously operate in their respective on-state during the first, second and third periods of time *tₐ, t_{b}, t_{c},* however, during a time period t1, t2, t3 a command signal is overridden to operate a drive transistor in the off-state. Between each of the periods of time *tₐ, t_{b}, t_{c},* one or more of the first plurality of transistors 12 may switch between its respective off-state and on-state.

Figure 4 shows graphs 32, 34, 36 corresponding to the control signal of each transistor LS1, LS2, LS3 of the first plurality of transistors 12. The graph 32 corresponds to first drive transistor LS1 and shows part of a control signal such that during the first, second, and third periods of time *tₐ, t_{b}, t_{c}* the first drive transistor LS1 is commanded to operate in its on-state. The graph 34 corresponds to the second drive transistor LS2 and shows part of a control signal such that during the first, second, and third periods of time *tₐ, t_{b}, t_{c}* the second drive transistor LS2 is commanded to operate in its on-state. The graph 36 corresponds to third drive transistor LS3 and shows part of a control signal such that during the first, second, and third periods of time *tₐ, t_{b}, t_{c}* the third drive transistor LS3 is commanded to operate in its on-state.

The graph 38 corresponds to the first sense transistor 19a (*LS*1*ₛₑₙ*) and shows part of a control signal such that during the first period of time *tₐ* the first sense transistor 19a is operated in an on-state when the first, second, and third drive transistors LS1, LS2, and LS3 are commanded to operate in the on-state. During the first time period t1, the first drive transistor LS1 is operated in an off-state (although, the first drive transistor LS1 may be commanded to operate in its on-state). In addition, during the first time period t1: a current flowing through the first sense transistor 19a is measured (IM1); a voltage difference between the first and second channel terminals of the second drive transistor LS2 is measured (*UM*1_{*LS*2}); and a voltage difference between the first and second channel terminals of the third drive transistor LS3 is measured *UM*1_{*LS*3}).

The graph 40 corresponds to the second sense transistor 19b (*LS*2*ₛₑₙ*) and shows part of a control signal such that during the second period of time *t_{b}* the second sense transistor 19b is operated in an on-state when the first, second, and third drive transistors LS1, LS2, and LS3 are commanded to operate in the on-state. During the second time period t2, the second drive transistor LS2 is operated in an off-state (although, the second drive transistor LS2 may be commanded to operate in its on-state). In addition, during the second time period t2: a current flowing through the second sense transistor 19b is measured (IM2); a voltage difference between the first and second channel terminals of the first drive transistor LS1 is measured (*UM*2_{*LS*1}); and a voltage difference between the first and second channel terminals of the third drive transistor LS3 is measured (*UM*2_{*LS*3}).

The graph 42 corresponds to the third sense transistor 19c (*LS*3*ₛₑₙ*) and shows part of a control signal such that during the third period of time *t_{c}* the third sense transistor 19c is operated in an on-state when the first, second, and third drive transistors LS1, LS2, and LS3 are commanded to operate in the on-state. During the third time period t3, the third drive transistor LS3 is operated in an off-state (although, the third drive transistor LS3 may be commanded to operate in its on-state). In addition, during the third time period t3: a current flowing through the third sense transistor 19c is measured (IM3); a voltage difference between the first and second channel terminals of the first drive transistor LS1 is measured (*UM*3_{*LS*1}); and a voltage difference between the first and second channel terminals of the second drive transistor LS2 is measured (*UM*3_{*LS*2}).

In an alternative example, the first, second, and third periods of time *tₐ, t_{b}, t_{c},* may be the same period of time when the first, second, and third drive transistors LS1, LS2, and LS3 are commanded to operate in the on-state. In this example, the time periods t1, t2, t3 are not the same time period, which ensures that accurate voltage difference measurements of drive transistors operating in the on-state may be taken.

The on-state resistance of the first drive transistor LS1 is based on: (a) the current measurement at the first sense transistor 19a (*LS*1*ₛₑₙ)*; and, (b) the measured voltage difference (*UM*1_{*LS*2}, *UM*1_{*LS*3}) between the first and second channel terminals D, S of the second and third drive transistors LS2, LS3 during the off-state of the first drive transistor LS1 (i.e., during the first time period t1).

After the first time period, the current measurement IM1 at the first sense transistor 19a (*LS*1*ₛₑₙ*), is known, and two measured voltage differences *UM*1_{*LS*2}, *UM*1_{*LS*3} between the first and second channel terminals D, S of the second and third drive transistors LS2, LS3 are known. These measured values may be provided to Equation (1) is shown below: $IM 1 + \left(UM{1}_{LS 2}∗R2\right) + \left(UM{1}_{LS 3}∗R3\right) = 0$ where R2 is the on-resistance of the second drive transistor LS2, and R3 is the on-resistance of the third drive transistor LS3.

The on-state resistance of the first drive transistor LS1 is further based on: (a) the current measurement at the second sense transistor *LS*2*ₛₑₙ* 19b and, (b) the measured voltage difference (*UM*2_{*LS*1}, *UM*2_{*LS*3}) between the first and second channel terminals D, S of the first and third drive transistors LS1, LS3 during the off-state of the second drive transistor LS2 (i.e., during the second time period t2).

After the second time period t2, the current measurement IM2 at the second sense transistor 19b (*LS*2*ₛₑₙ*) is known, and two measured voltage differences *UM*2_{*LS*1}, *UM*2_{*LS*3} between the first and second channel terminals D, S of the first and third drive transistors LS1, LS3 are known. These measured values may be provided to Equation (2) is shown below: $\left(UM{2}_{LS 1}∗R1\right) + IM 2 + \left(UM{2}_{LS 3}∗R3\right) = 0$ where R1 is the on-resistance of the first drive transistor LS1.

For two-phase motors and stepper motors, only two equations are required to determine the on-resistance of the first drive transistor LS1 because no third phase is present. Thus, the on-state resistance of the first drive transistor LS1 may be determined based on determining a current flowing through each of the first and second sense transistors 19a, 19b. For three-phase motors an additional measurement round may be conducted at third time period t3. Thus, the on-state resistance of the first drive transistor LS1 may be determined based on determining a current flowing through each of the first, second, and third sense transistors 19a, 19b, 19c.

The on-state resistance of the first drive transistor LS1 is further based on: (a) the current measurement at the third sense transistor 19c (*LS*3*ₛₑₙ*) and, (b) the measured voltage difference (*UM*3_{*LS*1}, *UM*3_{*LS*2}) between the first and second channel terminals D, S of the first and second drive transistors LS1, LS2 during the off-state of the third drive transistor LS3 (i.e., during the third time period t3).

After the third time period t3, the current measurement IM3 at the third sense transistor 19c is known, and two measured voltage differences *UM*3_{*LS*1}, *UM*3_{*LS*2} between the first and second channel terminals D, S of the first and second drive transistors LS1, LS2 are known. These measured values may be provided to Equation (3) is shown below: $\left(UM{3}_{LS 1}∗R1\right) + \left(UM{3}_{LS 2}∗R2\right) + IM 3 = 0$

Thus, each equation of equations (1), (2), and (3) each contain two unknowns (e.g., the on-resistances of two of the first plurality of transistors 12) which may be solved for. In addition, it is also known that while all of the first plurality of transistors 12 are in their on-state, the sum of the three individual coil currents by principle is 0 (because the system is balanced). For example, I1+I2+I3=Iu+Iv+Iw=0, where I1=IM1 during the first time period t1, I2=IM2 during the second time period, and I3=IM3 during the third time period.

Thus, the on-state resistance of each of the plurality of transistors 12 may be determined from equations (1), (2), and (3). Finally, the coil current of the motor 16 (called the motor current) may be determined based on the on-resistance of the first drive transistor LS1 and knowledge of the voltage measured over LS1 (e.g., *UM*2_{*LS*1}, *UM*3_{*LS*1}). As a result, the driver circuit 10 may control motor current while compensating for changes in the on-resistance of each of the first plurality of transistors 12 to yield a current measurement. The on-resistance of a transistor may change with a change in temperature.

In an example, the measurements may be repeated and the calculated on-resistance for any of the first plurality of transistors 12 may be filtered (or averaged) over a number of measurements. Beneficially, this may reduce any measurement noise. In addition, current measurements (e.g., IM1, IM2, IM3) which are near to zero may not be included in the filtering (or averaging). Beneficially, higher current measurements (e.g., near the limits of each calibration interval *tₐ, t_{b}, t_{c}*) provide higher precision, and may be preferred. In an example, the time periods (e.g., t1, t2, t3) corresponding to measurements may be performed when appropriate during operation, and may be performed in any order or sequence.

Thus, the on-state resistance of the first drive transistor LS1 is determined based on determining a current flowing through each of the first and second sense transistors 19a, 19b.

The first method may require a first drive transistor LS1 with current mirroring (i.e., first sense transistor 19a) which may be integrated into the pre-driver (e.g., IC), that is capable of working with the full application voltage and conducting a certain percentage of the normal / mean application current (e.g. 10% to 20%) for a limited time of a few microseconds, and may repeat (e.g., in a pattern of a few milliseconds or faster).

To provide a practical example, a power stage for 15A RMS current may be used for an e-Bike with 50A short time peak current. If re-calibration is limited to a current of up to 2A, and the sense transistor has an on-resistance of 500mOhm, there is a voltage drop of 1V for the measurement time (e.g., t1, t2, t3) of a few microseconds, then the mean power dissipation with a duty cycle of estimated <<1% is ~<10mW. This represents an efficiency improvement over in-line current sensing techniques.

The example of Figure 4 provides an iterative approach to determining the on-state resistance of the first drive transistor LS1. In an alternative example, the on-state resistance of the first drive transistor LS1 may be determined in a single period of time (e.g., *tₐ*). For example, during a time period (e.g., t1), one of the first plurality of transistors 12 may be operated in the on-state (e.g., LS1), and the remaining of the first plurality of transistors 12 may be operated in the off-state (e.g., LS2, LS3). In addition, during the time period (e.g., t1), the sense FETs corresponding to the remaining of the first plurality of transistors 12 may be operated in the on-state (e.g., *LS*2*ₛₑₙ, LS*3*ₛₑₙ*), and sense FET corresponding to the one of the first plurality of transistors 12 may be operated in the off-state (e.g., *LS*1*ₛₑₙ*). From this example, measured values may be provided to Equation (4) is shown below: $\left(UM{3}_{LS 1}∗R1\right) + IM 2 + IM 3 = 0$

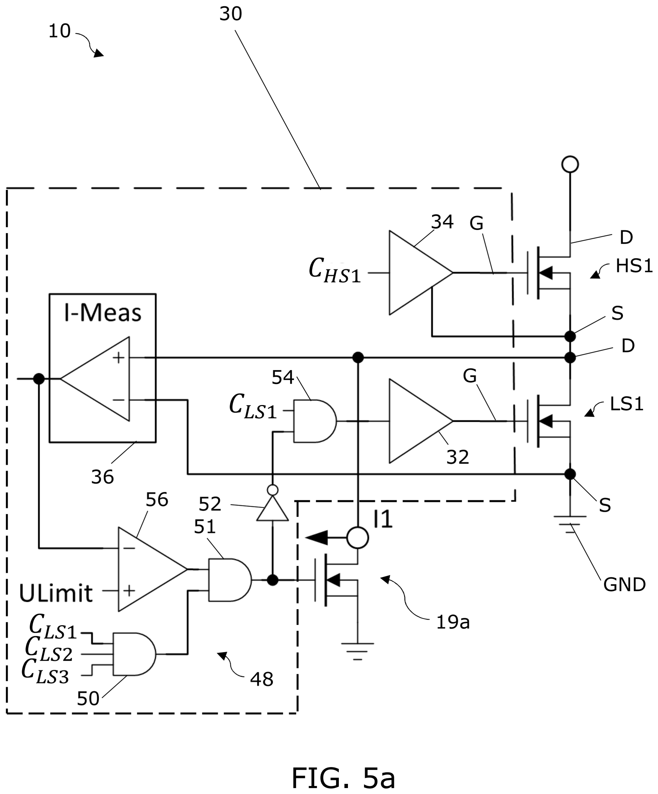

Figure 5a shows an example circuit 30 for performing a method described herein. Figure 5a only shows the components for one of the first plurality of transistors 12. However, it will be understood that a driver circuit 10 may comprise additional circuits similar to the circuit 30, each corresponding to one transistor of the first plurality of transistors 12.

Figure 5a shows the first drive transistor LS1 of the first plurality of transistors 12, and its corresponding first HS transistor HS1 of the second plurality of transistors 14.

A measurement component 36 is configured to receive a voltage difference between the first and second channel terminals of the first drive transistor LS1, and to generate a signal corresponding to the voltage difference between the first and second channel terminals of the first drive transistor LS1. The measurement component 36 may be a current sense amplifier, which may be as simple as those suitable for use with footpoint-shunt resistor amplifiers.

Figure 5a also shows a circuit configured to receive the first command signal *C*_{*LS*1}, an override signal, and generate the first control signal *G*_{*LS*1} for the first drive transistor LS1. The override signal may be based on the on-state and/or off-state of each of the first plurality of transistors 12. The first drive transistor LS1 may be operated (with the first control signal *G*_{*LS*1}) based on the command signal *C*_{*LS*1} and the override signal. The circuit may only generate the first control signal *G*_{*LS*1} if the first command signal *C*_{*LS*1} commands the first drive transistor LS1 to be in the on-state and the override signal allows the first command signal *C*_{*LS*1} to generate the first control signal *G*_{*LS*1}.

In the example of Figure 5a, the override signal is further based on: the voltage difference between the first and second channel terminals of the first drive transistor; and, a first sense transistor limitation threshold (Ulimit). A comparator 56 may be configured to determine if the voltage difference (IMeas) between the first and second channel terminals of the first drive transistor LS1 is less than the first sense transistor limitation threshold (Ulimit). The override signal may be further based on the output of a comparator 56.

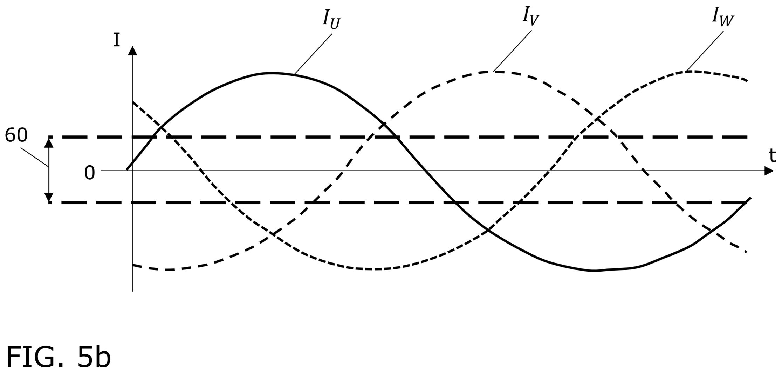

The comparator 56 is configured to compare a voltage difference (IMeas) between the first and second channel terminals of the first drive transistor LS1 to the first sense transistor limitation threshold (Ulimit). When the voltage difference is less than the first sense transistor limitation threshold (Ulimit), the first sense transistor 19a may be operated in the on-state. When the voltage difference is less than the first sense transistor limitation threshold (Ulimit), the first drive transistor LS1 is operated in the off-state. The first sense transistor limitation threshold (Ulimit) may be less than the amplitude of the operating current (e.g., the peak amplitude of the operating current). Advantageously, the use of the first sense transistor limitation threshold (Ulimit) protects the first sense transistor 19a from overcurrent conduction, if the first sense transistor is a low power-rated device. In alternative examples, other implementation means may be used to achieve the desired functionality. Figure 5b shows a graph of the current in each motor coil over time, with a measurement window 60 corresponding to the first sense transistor limitation threshold (Ulimit) shown. That is, the first sense transistor 19a may only conduct the operating current within the measurement window 60. The other sense transistors 19b, 19c, when present, may be controlled similarly to the first sense transistor 19a as discussed above.

As shown in Figure 5a, the override signal may be generated by: a first AND gate 50 configured to receive the command signals *C*_{*LS*1}, *C*_{*LS*2}, *C*_{*LS*3} of the first plurality of transistors 12 as inputs; the comparator 56; a second AND gate 51; and a NOT gate 52. The second AND gate 51 is arranged to receive the output of the comparator 56 and the first AND gate 50. The output of the second AND gate 51 may be arranged to generate the control signal of the first sense transistor 19a. The output of the second AND gate 51 may further be arranged to be input into the NOT gate 52. The NOT gate 52 may generate the override signal. In alternative examples, other implementation means may be used to achieve the same functionality.

The command signals *C*_{*LS*1}, *C*_{*LS*2}, *C*_{*LS*3} may be generated by the one or more processors (e.g., the controller 17) for PWM control of the motor.

An optional first amplifier 32 is arranged to provide the control signal *G*_{*LS*1} to the first drive transistor LS1 of the first plurality of transistors 12. An optional second amplifier 34 is arranged to provide the control signal *G*_{*HS*1} to the first HS transistor HS1 of the second plurality of transistors 14 in response to receiving a first HS command signal *C*_{*HS*1}.

Figures 3 and 4 describe a simple way to determine the on-state resistance of at least the first drive transistor LS1, by redirecting the operating current I1, I2, I3 from one of the plurality of transistors 12 into a respective sense transistor 19a, 19b, 19c. However, two or more additional voltage measurements UM0, UM2 per transistor may be made if the operating current is shared between a drive transistor and a respective sense transistor. Advantageously, when determining an on-state resistance of a drive transistor, any measurement offset may be compensated for when making one or more additional measurements per drive transistor.

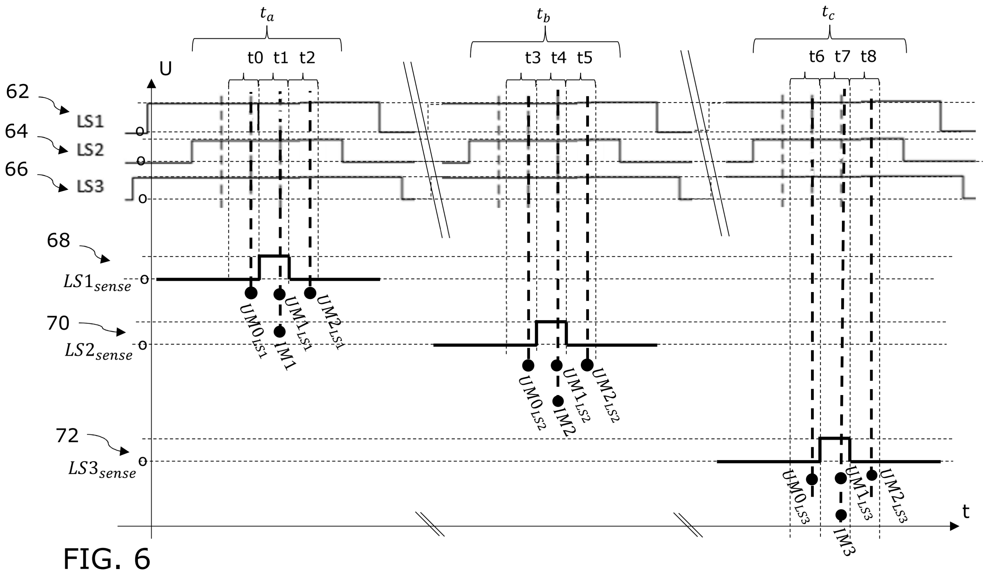

A second method of determining an on-state resistance of a first drive transistor in a drive system for operating a motor 16 is described with reference to Figures 6 to 8.

In examples, a PWM duty cycle may be lower and may allow for multiple current samples (e.g., UM0, UM1, UM2) per a period of time *tₐ*, when all of the first plurality of transistors 12 are in their on-state.

As shown in Figure 6, the first command signal *C*_{*LS*1} is the first control signal *G*_{*LS*1}, the second command signal *C*_{*LS*2} is the second control signal *G*_{*LS*2}, and the third command signal *C*_{*LS*3} is the third control signal *G*_{*LS*3}.

The first period of time *tₐ* comprises time periods t0, t1, t2. The second period of time *t_{b}* comprises time periods t3, t4, t5. The third period of time *t_{c}* comprises time periods t6, t7, t8. Each of the first plurality of transistors 12 are configured to simultaneously operate in their respective on-state during the first, second and third periods of time *tₐ, t_{b}, t_{c}.* Between each of the periods of time *tₐ, t_{b}, t_{c},* one or more of the first plurality of transistors 12 may switch between its respective off-state and on-state.

Figure 6 shows graphs 62, 64, 66 corresponding to the control signal *G*_{*LS*1}*, G*_{*LS*2}*, G*_{*LS*3} of each drive transistor LS1, LS2, LS3 of the first plurality of transistors 12. The graph 62 corresponds to the first drive transistor LS1 and shows part of a pulse width modulation (PWM) control signal such that during the first, second, and third periods of time *tₐ, t_{b}, t_{c}* the first drive transistor LS1 is in its on-state. The graph 64 corresponds to the second drive transistor LS2 and shows part of a PWM control signal such that during the first, second, and third periods of time *tₐ, t_{b}, t_{c}* the second drive transistor LS2 is in its on-state. The graph 66 corresponds to the third drive transistor LS3 and shows part of a PWM control signal such that during the first, second, and third periods of time *tₐ, t_{b}, t_{c}* the transistor LS3 is in its on-state.

The graphs 68, 70, 72 correspond to the control signal for each sense transistor 19a, 19b, 19c. The graph 68 shows the control signal of the first sense transistor 19a such that: during the initial time period t0, the first sense transistor 19a is operated in the off-state; during the first time period t1, the first sense transistor 19a is operated in the on-state; during the second time period t2, the first sense transistor 19a is operated in the off-state. The graph 70 shows the control signal of the second sense transistor 19b such that: during the third time period t3, the second sense transistor 19b is operated in the off-state; during the fourth time period t4, the second sense transistor 19b is operated in the on-state (and the second drive transistor LS2 is operated in the on-state); during the fifth time period t5, the second sense transistor 19b is operated in the off-state. The graph 72 shows the control signal of the third sense transistor 19c such that: during the sixth time period t6, the third sense transistor 19c is operated in the off-state; during the seventh time period t7, the third sense transistor 19c is operated in the on-state (and the third drive transistor LS3 is operated in the on-state); during the eighth time period t8, the third sense transistor 19c is operated in the off-state.

During the first time period t1, operating current I1 is applied through the first and second channel terminals of the first drive transistor LS1 and through the first and second channel terminals of the first sense transistor 19a. A voltage difference measurement *UM*0_{*LS*1} between the first and second channel terminals of the first drive transistor LS1 may be measured during the initial time period t0. A voltage difference measurement *UM*1_{*LS*1} between the first and second channel terminals of the first drive transistor LS1 may be measured during the first time period t1. A voltage difference measurement *UM*2_{*LS*1} between the first and second channel terminals of the first drive transistor LS1 may be measured during the second time period t2.

During the fourth time period t4, operating current I2 is applied through the first and second channel terminals of the second drive transistor LS2 and through the first and second channel terminals of the second sense transistor 19b. A voltage difference measurement *UM*0_{*LS*2} between the first and second channel terminals of the second drive transistor LS2 may be measured during the third time period t3. A voltage difference measurement *UM*1_{*LS*2} between the first and second channel terminals of the second drive transistor LS2 may be measured during the fourth time period t4. A voltage difference measurement *UM*2_{*LS*2} between the first and second channel terminals of the second drive transistor LS2 may be measured during the fifth time period t5.

During the seventh time period t7, operating current I3 is applied through the first and second channel terminals of the third drive transistor LS3 and through the first and second channel terminals of the third sense transistor 19c. A voltage difference measurement *UM*0_{*LS*3} between the first and second channel terminals of the third drive transistor LS3 may be measured during the sixth time period t6. A voltage difference measurement *UM*1_{*LS*2} between the first and second channel terminals of the third drive transistor LS3 may be measured during the seventh time period t7. A voltage difference measurement *UM*2_{*LS*3} between the first and second channel terminals of the third drive transistor LS3 may be measured during the eighth time period t8.

The voltage difference measurements UM0, UM1, UM2 for each transistor of the first plurality of transistors 12 may be made during a respective period of time *tₐ, t_{b}, t_{c}.*

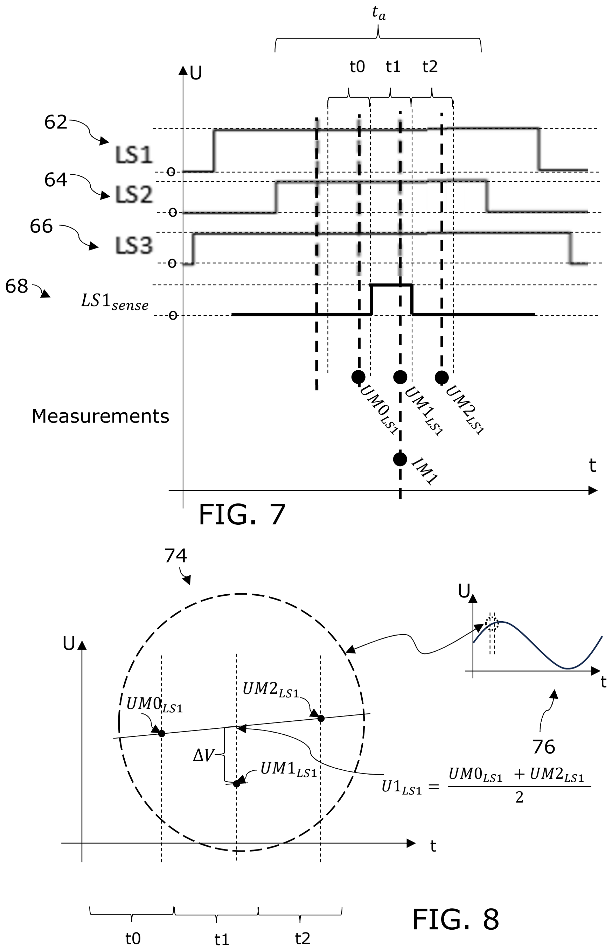

Figure 7 shows a sub-section the Figure 6 corresponding to the first period of time *tₐ* and graphs 62, 64, 66, and 68. The measurements made during the period of time *tₐ* of Figure 6 equate to the measurements made during the period of time *tₐ* of Figure 7. Only a single period of time *tₐ* is shown in Figure 7 for explanatory purposes only, and the method of determining each of the on-state resistance of each transistor LS1, LS2, LS3 of the first plurality of transistors 12 may be determined similarly to the method described below with reference to Figure 7.

Figure 7 is shown to aid in the explanation of Figure 8. Figure 8 shows a graph 74 representing the change in voltage between the initial time period t0 and the second time period t2 (inclusive) corresponding to the first drive transistor LS1. A graph 76 shows change in voltage corresponding to the u-phase of the motor (corresponding to the first drive transistor LS1) over a full cycle, to provide context relative (but not to scale) to the graph 74.

Turning to graph 74 of Figure 8, during an initial time period t0, an initial voltage difference measurement *UM*0_{*LS*1} is measured between the first and second channel terminals of the first drive transistor LS1. During the first time period t1, after the initial time period t0, a first voltage difference measurement *UM*1_{*LS*1} is measured between the first and second channel terminals of the first drive transistor LS1. During the second time period t2, after the first time period t1, a second voltage difference measurement *UM*2_{*LS*1} is measured between the first and second channel terminals of the first drive transistor LS1. The on-state resistance of the first drive transistor LS1 may be determined based on the first, second, and third voltage difference measurements *UM*0_{*LS*1}, *UM*1_{*LS*1}, *UM*2_{*LS*1}. The initial time period t0 is before the first time period t1. The second time period t2 is after the first time period t1.

Three voltage difference measurements *UM*0_{*LS*1}, *UM*1_{*LS*1}, *UM*2_{*LS*1} are made while all of the first plurality of transistors 12 are simultaneously in their on-state (i.e., during the period of time *tₐ*). The first sense transistor 19a is operated in the on-state during the first voltage difference measurement *UM*1_{*LS*1}.

Specifically, turning to the example of Figures 7 and 8, and as shown in graph 68, the first sense transistor 19a is operated in the on-state during a first time period t1. A current measurement IM1 at the first sense transistor 19a is made during the first time period t1. The first voltage difference measurement *UM*1_{*LS*1} is made while the first sense transistor 19a is operated in the on-state, and the first drive transistor LS1 is operated in the on-state. As a result, the voltage difference (relative to the reference voltage, e.g., GND) of the first voltage difference measurement *UM*1_{*LS*1} will be less than the coil voltage *U*1_{*LS*1} by an amount Δ*V* due to the parallel arrangement of the first drive transistor LS1 and the first sense transistor 19a. The first voltage difference measurement *UM*1_{*LS*1} and the current measurement IM1 may be made at the same time.

Second and third sense transistors 19b, 19c (and associated measurements) corresponding to the second and third drive transistors LS2, LS3 may also be operated in their on-state during the fourth and seventh time periods as shown with reference to Figure 6. In an alternative example, second and third sense transistors 19b, 19c (and associated measurements) corresponding to the second and third drive transistors LS2, LS3 may also be operated in their on-state during the first time period t1, similarly to the example described above for the first drive transistor LS1.

The on-state resistance (*Ron*_{*LS*1}) of the first drive transistor LS1 can be determined based on the voltage difference measurements *UM*0_{*LS*1}, *UM*1_{*LS*1}, *UM*2_{*LS*1} and the current measurement IM1 of the current flowing through the first sense transistor 19a during the first time period t1. The on-state resistance (*Ron*_{*LS*1}) of the first drive transistor LS1 can be determined from the equations (5) and (6) below: $U {1}_{LS 1} = \frac{UM {0}_{LS 1} + UM {2}_{LS 1}}{2}$ ${Ron}_{LS 1} = \frac{U {1}_{LS 1} - UM {1}_{LS 1}}{IM 1}$

Equation (5) assumes that the coil voltage changes linearly during the time period between t0 to t2 (e.g., as shown in Figure 8). This may be a valid assumption on short time-scales, however, more accurate models/equations may be used to determine the on-state resistance (*Ron*_{*LS*1}) of the first drive transistor LS1. In an alternative example, to increase the accuracy of the determination of the on-state resistance (*Ron*_{*LS*1}) of the first drive transistor LS1, the first voltage difference measurement *UM*1_{*LS*1} can be skipped or weighted depending on the change between the initial and second voltage difference measurements *UM*0_{*LS*1} and *UM*2_{*LS*1}. Equations (5) and (6) may similarly be applied to determine the on-state resistance (*Ron*_{*LS*2}) of the second drive transistor LS2, and the on-state resistance (*Ron*_{*LS*3}) of the third transistor LS3.

In examples, the parallel sense transistors 19a, 19b, 19c may have a sufficiently low on-resistance in the range of less than 5, 6, 8, or 10 times the on-resistance of one of the first plurality of transistors 12. Advantageously, this may improve the accuracy of a current measurement IM1, IM2, IM3 at a corresponding sense transistor 19a, 19b, 19c.

The first time period t1 may at least cover the minimum required time to perform the voltage difference measurement *UM*1_{*LS*1} (e.g. 2µs) and may be appended to the time required for a measurement *UM*0_{*LS*1}, *UM*2_{*LS*1}.

Individual on-state resistance measurements for each of the first plurality of transistors 12, can be determined based on doing three consecutive measurements UM0, UM1 and UM2. Assuming a linear change of individual coil current for a short measurement interval, the individual phase current for I1, I2 or I3 at the time of measurement UM1 is the mean value measured for UM0 and UM2. With this, the voltage difference measurement for all of the first plurality of transistors 12 may be determined with and without the corresponding sense transistor 19a, 19b, 19c operating in the on-state. When measuring the voltage difference over the on-state resistance of the external power transistors (i.e., the first plurality of transistors 12), a relatively low voltage has to be measured, as power transistors are optimized for low resistance and thus low voltage drop. Measuring a low voltage may be prone to offset errors and can cause significant measurement error. The principles of the second method may eliminate this offset error because the measurement is differential, i.e. is measured with (e.g., UM1) and without (e.g., UM0, UM2) the parallel sense transistor 19a operated in the on-state, thus eliminating/reducing offset error as a source of error for determining the on-state resistance of the first drive transistor LS1.

In the example of Figures 6 and 7, each of the first plurality of transistors 12 is operated in the on-state continuously during the initial, first, and second time periods t0, t1, t2. Each of the first, second, and third sense transistors 19a, 19b, 19c may be operated in an on-state when the first plurality of transistors 12 are commanded to simultaneously operate in the on-state.

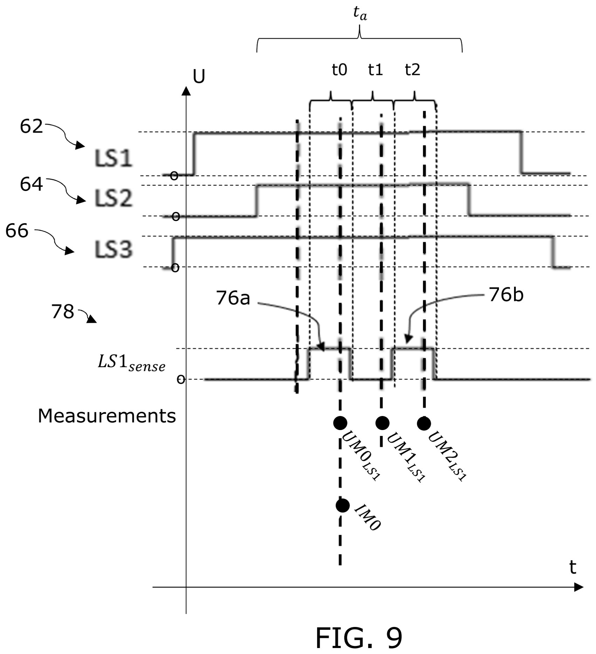

Figure 9 shows graphs 62, 64, 66 corresponding to the control signal of each transistor LS1, LS2, LS3 of the first plurality of transistors 12. The graphs 62, 64, 66 are the same as the graphs 62, 64, 66 of Figure 7 and will not be described again.

Figure 9 shows an alternative control signal pattern graph 78 to the control signal pattern graph 68 shown in Figure 7 (and used in Figure 8). The graph 78 shows a control signal for operating the first sense transistor 19a in the on-state of during the first period of time *tₐ*.

As shown in Figure 9, the first sense transistor 19a is operated in the on-state during an initial and second time period t0, t2. The first sense transistor 19a is operated in the on-state during the initial time period t0 (as shown with control signal pulse 76a). The first sense transistor 19a is operated in the off-state during the first time period t1. The first sense transistor 19a is operated in the on-state during the second time period t2 (as shown with control signal pulse 76b). The initial voltage difference measurement *UM*0_{*LS*1} between the first and second channel terminals of the first drive transistor LS1 is measured during the initial time period t0. The first voltage difference measurement *UM*1_{*LS*1} between the first and second channel terminals of the first drive transistor LS1 is measured during the first time period t1. The second voltage difference measurement *UM*2_{*LS*1} between the first and second channel terminals of the first drive transistor LS1 is measured during the second time period t2. Since the measurements *UM*0_{*LS*1}, *UM*1_{*LS*1}, *UM*2_{*LS*1} for the first transistors 12 is known with and without the first sense transistor 19a operating in the on-state, the on-state resistance (*Ron*_{*LS*1}) of the first drive transistor LS1 can be determined based on the voltage difference measurements *UM*0_{*LS*1}, *UM*1_{*LS*1}, *UM*2_{*LS*1}. In the example of Figure 9, each of the first plurality of transistors 12 is operated in the on-state continuously during the initial, first, and second time periods t0, t1, t2.

A current measurement IM0 at the first sense transistor 19a is made during the initial time period t0. The on-state resistance (*Ron*_{*LS*1}) of the first drive transistor LS1 can be determined based on the voltage difference measurements *UM*0_{*LS*1}, *UM*1_{*LS*1}, *UM*2_{*LS*1} and the current measurement IM0 of the current flowing through the first sense transistor 19a during the initial time period t0. The equations required may be similar to / derived based on equations (5) and (6).

This method may be repeated simultaneously for the other transistors LS2, LS3 of the first plurality of transistors 12. Thus, the voltage difference measurements for the first plurality of transistors 12 may be determined with and without the corresponding sense transistor 19a, 19b, 19c operating in the on-state.

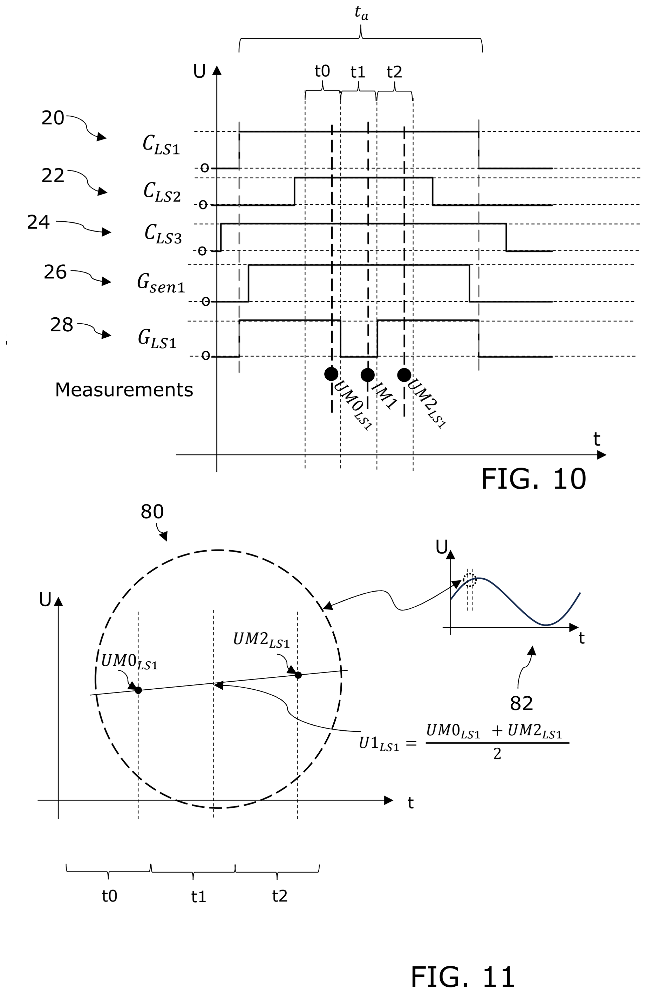

A third method of determining an on-state resistance of a first drive transistor in a drive system for operating a motor 16 is described with reference to Figures 10 and 11.

Figure 10 shows graphs 20, 22, 24 corresponding to the command signal *C*_{*LS*1}, *C*_{*LS*2}, *C*_{*LS*3} of each drive transistor LS1, LS2, LS3 of the first plurality of transistors 12 during the first period of time *tₐ*. The graph 26 corresponds to the control signal *G*_{*sen*1} of the first sense transistor 19a during the first period of time *tₐ*. The graph 28 corresponds to the control signal *G*_{*LS*1} of the first drive transistor LS1 during the first period of time *tₐ.* The graphs 20, 22, 24, 26, 28 are the same as the graphs 20, 22, 24, 26, 28 of Figure 3 and will not be described again.

Figure 11 is shown to aid in the explanation of Figure 10 (similar to the described Figures 7 and 8). Figure 11 shows a graph 80 representing the change in voltage between the initial time period t0 and the second time period t2 (inclusive) corresponding to the first drive transistor LS1. A graph 82 shows change in voltage corresponding to the u-phase of the motor (corresponding to the first drive transistor LS1) over a full cycle, to provide context relative (but not to scale) to the graph 80.

During an initial time period t0, an initial voltage difference measurement *UM*0_{*LS*1} is measured between the first and second channel terminals of the first drive transistor LS1. A current measurement IM1 at the first sense transistor 19a is made during the first time period t1. During the second time period t2, after the first time period t1, a second voltage difference measurement *UM*2_{*LS*1} is measured between the first and second channel terminals of the first drive transistor LS1. The on-state resistance of the first drive transistor LS1 may be determined based on the initial voltage difference measurement *UM*0_{*LS*1}, the current measurement IM1, and the second voltage difference measurement *UM*2_{*LS*1}. The initial time period t0 is before the first time period t1. The second time period t2 is after the first time period t1.

The on-state resistance (*Ron*_{*LS*1}) of the first drive transistor LS1 can be determined from the equations (7) and (8) below: $U {1}_{LS 1} = \frac{UM {0}_{LS 1} + UM {2}_{LS 1}}{2}$ ${Ron}_{LS 1} = \frac{U {1}_{LS 1}}{IM 1}$

Equation (7) (similarly to Equation 5) assumes that the coil voltage changes linearly during the time period between t0 to t2 (e.g., as shown in Figure 11). This linear assumption may be a valid assumption on short time-scales, however, more accurate models/equations may be used to determine the on-state resistance (*Ron*_{*LS*1}) of the first drive transistor LS1 based on the initial voltage difference measurement *UM*0_{*LS*1} and the second voltage difference measurement *UM*2_{*LS*1}.

In an example, this method may be repeated to determine the on-state resistance of the second drive transistor LS2 and/or the third drive transistor LS3 in different periods of time *tₐ, t_{b}, t_{c}* (similarly to Figures 4 and 6). In another example, this method may be repeated simultaneously for the other transistors LS2, LS3 of the first plurality of transistors 12. Thus, the voltage difference measurements for the first plurality of transistors 12 may be determined with and without the corresponding sense transistor 19a, 19b, 19c operating in the on-state.

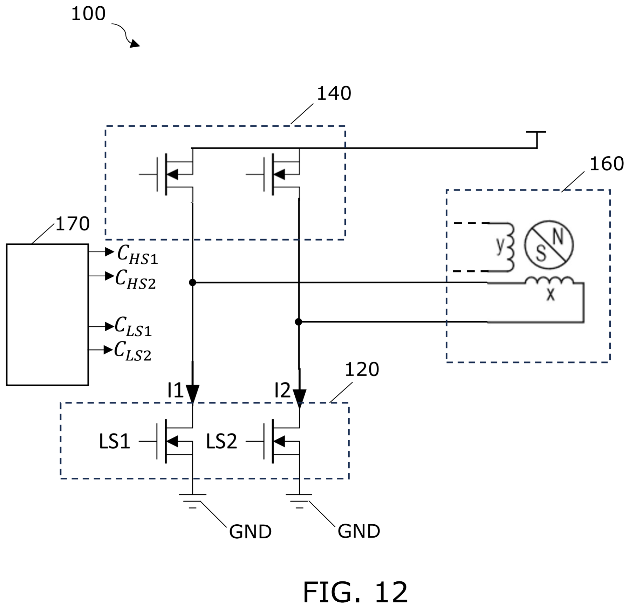

The examples of Figures 1a to 11 are shown for a 3-phase motor. However, in a two-phase motor, or stepper motor, only two periods of time, e.g., *tₐ, t_{b}* may be needed for the equations to be complete. Figure 12 shows an example of a schematic block wiring diagram of a driver circuit 100 coupled to a stepper motor 160 for carrying out the methods described with reference to Figures 2 to 11. For example, each coil of the motor corresponds to a 2-phase control system, thus only two periods of time, e.g., *tₐ,t_{b}* may be needed for the equations described to be complete, as would be understood by the skilled person. The driver circuit 100 comprises a first plurality of transistors 120, e.g., Low Side (LS) drive transistors, corresponding to a coil of the motor 160 (e.g., LS1 and LS2 corresponding to an x-coil). The driver circuit 100 comprises a second plurality of transistors 140, e.g., High Side (HS) drive transistors, each corresponding to a LS drive transistor. Each transistor of the driver circuit 100 comprises a control terminal (e.g., Gate G), a first channel terminal (e.g., Drain D), and a second channel terminal (e.g., Source S). Each transistor of the driver circuit 100 is also arranged to be in an on-state or an off-state. For simplicity, the drive transistors corresponding to the y-coil of the stepper motor are not shown, but are present and arranged similarly to the transistors corresponding to the x-coil, as would be understood by the skilled person. In operation, a controller 170 switches the first and second plurality of transistors 120, 140 to operate the motor 16 using an operating current.

In an example, the sense transistors 19a, 19b, 19c may be a low voltage (e.g., 5V) device, in so far as they can withstand the full motor voltage in the off-state. The sense transistors 19a, 19b, 19c may be low power-rated device which can withstand only a fraction of the full motor current (with careful control, as discussed herein).

In any example, the one or more time periods (e.g., t0, t1, t2, etc.) may be adjusted based on the relative value of the motor current. The one or more time periods (e.g., t1, t2, etc.) may be adjusted based on the change of the motor current within the previous time period (e.g., t0, t1, etc. respectively). This way, calibration duty cycle can be reduced further.

In an example, the driver circuit 10, 100 drives a load. The load may be a resistive load, an inductive load, or a motor. The driver circuit 10, 100 may be a motor drive circuit configured to drive a motor. The drive system may be a motor drive system.

In an alternative example, a scheme of switching the first plurality of transistors 12 (e.g., PWM scheme) may not offer sufficiently long on-times of the first plurality of transistors 12 for corresponding voltage difference measurements to take place. In this example, the scheme of switching may be overridden to generate sufficiently long on-times of the first plurality of transistors 12 for corresponding voltage difference measurements to take place, before transitioning back to the original scheme of switching.

Although the examples are described with reference to LS transistors. In alternative examples, the methods herein may also be performed with reference to the HS drive transistors. In an example, the methods herein may be performed with reference to LS and HS drive transistors.

In an example, one or more of the sense transistors 19a, 19b, 19c are physically smaller (e.g., dimensioned) transistors than the drive transistors LS1, LS2, LS3, HS1, HS2, HS3. In an example, one or more of the sense transistors 19a, 19b, 19c have a lower power rating than the drive transistors LS1, LS2, LS3, HS1, HS2, HS3. A power rating will be understood as the number of watts each transistor can safely dissipate without sustaining damage. Each sense transistor may have a greater on-resistance than its corresponding drive transistor. Each sense transistor 19a, 19b, 19c may be a FET, such as a MOSFET, or JFET. Each drive transistor LS1, LS2, LS3 may be a FET, such as a MOSFET, or JFET.

Each sense transistor 19a, 19b, 19c may be implemented with a sense resistor in series. The sense resistor may be coupled between a respective sense transistor and the reference voltage (GND).

### General

Each block of the Figures is shown and defined for explanatory purposes only, it would be well understood that the algorithm or function which each block represents may be implemented in a plurality of other ways so long as the functionality as described is present. For example, blocks may be combined and implemented as part of a circuit arrangement, on a single integrated circuit, processor, or computer, or implemented by a plurality of circuit arrangements, integrated circuits, processors, and/or computers.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to."

The words "coupled" or "connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. Moreover, in the following claims, the terms "initial", "first", "second", "third", "fourth", etc. are used merely as labels, and are not intended to impose numerical requirements on their objects. Methods examples described herein can be machine or computer-implemented at least in part.

It is to be understood that one or more features from one or more of the above- described embodiments may be combined with one or more features of one or more other ones of the above-described embodiments, so as to form further embodiments which are within the scope of the appended claims.

### NUMBERED CLAUSES

By way of non-limiting example, some aspects of the disclosure are set out in the following numbered clauses, with example reference numerals.

Clause 1. A method of determining a resistance of a first drive transistor in a drive system for operating a motor, the drive system comprising a first drive transistor, a first sense transistor, and a second drive transistor, wherein the first sense transistor is arranged in parallel with the first drive transistor, each transistor comprising a control terminal, a first channel terminal, and a second channel terminal, the method comprising: switching the first and second drive transistors to operate the motor using an operating current, wherein current is configured to flow between the first and second channel terminals of each drive transistor in an on-state such that the operating current flows between motor coils of the motor and a reference node, and wherein the reference node is shared by each of the transistors; and operating the first sense transistor to determine the on-state resistance of the first drive transistor, wherein the operating current flows between motor coils of the motor and the reference node through the first sense transistor.

Clause 2. The method of clause 1, wherein the drive system further comprises a second sense transistor corresponding to the second drive transistors and arranged in parallel with the second drive transistor, the method further comprising: operating the second sense transistor to determine the on-state resistance of the first drive transistor, wherein the operating current flows between motor coils of the motor and the reference node through the second sense transistor.

Clause 3. The method of any one of clauses 1 or 2, wherein the on-state resistance of the first drive transistor is determined based on determining a current flowing through each of the first and second sense transistors.

Clause 4. The method of any preceding clause, wherein the method further comprises: determining the motor current based on a measured voltage and the on-resistance of the first drive transistor.

Clause 5. The method of any preceding clause, wherein operating the first and second sense transistors comprises: operating the first sense transistor in an on-state when the first drive transistor is commanded to operate in an on-state.

Clause 6. The method of clause 5, wherein operating the first and second sense transistors comprises: operating the first sense transistor in an on-state when the second drive transistor is commanded to operate in the on-state.

Clause 7. The method of any one of clauses 5 or 6, when the first sense transistor is operated in the on-state and the first drive transistor is commanded to operate in the on-state: operating the first drive transistor in an off-state for a first time period; measuring a current flowing through the first sense transistor during the first time period; and, measuring a voltage difference (UM1) between the first and second channel terminals of the second drive transistor during the first time period.

Clause 8. The method of any one of clauses 5 or 6, further comprising: during a first time period (t0), operating the first drive transistor in the on-state; and, measuring a first voltage difference (UM0) between the first and second channel terminals of the first drive transistor; during a second time period (t1), operating the first drive transistor in the on-state; measuring a second voltage difference (UM1) between the first and second channel terminals of the first drive transistor; and, operating the first sense transistor in on-state during the second time period (t1); during a third time period (t2), operating the first drive transistor in the on-state; and, measuring a third voltage difference (UM2) between the first and second channel terminals of the first drive transistor, wherein determining the on-state resistance of the first drive transistor is based on the measured first, second, and third voltage differences.

Clause 9. The method of clause 8, further comprising: during the first time period (t0), operating the first sense transistor in the off-state, wherein the first sense transistor is operated in the on-state during the second time period (t1); during the third time period (t2), operating the first sense transistor in the off-state.

Clause 10. The method of any one of clauses 8 or 9, further comprising: operating each of the first and second drive transistors in the on-state continuously during the first and second time periods (t0, t1).

Clause 11. The method of any preceding clause, wherein operating the first and second sense transistors comprises: operating the second sense transistor in an on-state when the second drive transistor is commanded to operate in an on-state.

Clause 12. The method of clause 11, wherein the second sense transistor is operated in an on-state when the first and second drive transistors are commanded to operate in the on-state.

Clause 13. The method of any one of clauses 11 or 12, when the second sense transistor is operated in the on-state and the second drive transistor is commanded to operate in the on-state: operating the second drive transistor in an off-state for a second time period; measuring a current flowing through the second sense transistor during the second time period; and, measuring a voltage difference (UM1) between the first and second channel terminals of the first drive transistor during the second time period.

Clause 14. The method of any one of clauses 11 or 12, during a fourth time period (t3), operating the second drive transistor in the on-state; and, measuring the fourth voltage difference (UM0) between the first and second channel terminals of the second drive transistor; during a fifth time period (t4), operating the second drive transistor in the on-state; and, measuring a fifth voltage difference (UM1) between the first and second channel terminals of the second drive transistor; during a sixth time period (t5), operating the second drive transistor in the on-state; and, measuring a sixth voltage difference (UM2) between the first and second channel terminals of the second drive transistor, wherein determining the on-state resistance of the first drive transistor is based on the measured fourth, fifth, and sixth voltage differences.

Clause 15. The method of clause 14, further comprising: during the fourth time period (t3), operating the second sense transistor in the off-state, wherein the second sense transistor is operated in the on-state during the fifth time period (t4);
during the sixth time period (t5), operating the second sense transistor in the off-state.

Clause 16. The method of any preceding clause, further comprising: comparing a voltage difference (IMeasure) between the first and second channel terminals of the first drive transistor to a first sense transistor limitation threshold (Ulimit), wherein when the voltage difference is less than the first sense transistor limitation threshold (Ulimit), operating the first sense transistor in the on-state.

Clause 17. The method of clause 16, wherein when the voltage difference is less than the first sense transistor limitation threshold (Ulimit), operating the first drive transistor in the off-state.

Clause 18. The method of any one of clauses 16 or 17, wherein the first sense transistor limitation threshold (Ulimit) is less than the amplitude of the operating current.

Clause 19. A driver circuit comprising: first and second drive transistors and corresponding first and second sense transistors, wherein each sense transistor is arranged in parallel with a respective one of the drive transistors, the first and second drive transistors arranged to drive a load, each transistor comprising a control terminal, a first channel terminal, and a second channel terminal, wherein current is configured to flow between the channel terminals of each drive transistor in an on-state such that an operating current flows between motor coils of the motor and a reference node, wherein the reference node is shared by each of the transistors; and one or more processors configured to perform the method of any one of clauses 1 to 18.

Clause 20. The driver circuit of clause 19, further comprising a logic circuit configured to: receive a command signal configured to operate the first drive transistor, wherein the command signal is generated by the one or more processors for PWM control of the motor; receive an override signal based on the on-state and/or off-state of each of the drive transistors; operate the first drive transistor based on the command signal and the override signal.

Clause 21. The driver circuit of clause 20, wherein the override signal is further based on: the voltage difference between the first and second channel terminals of the first drive transistor; and, a first sense transistor limitation threshold (Ulimit).

Clause 22. The driver circuit of any one of clauses 19 to 21, wherein the one or more processors comprise a gate driver integrated circuit, and the gate driver integrated circuit comprises the sense transistors, wherein the drive transistors are external to the one or more processors.

Clause 23. The driver circuit of any one of clauses 19 to 22, wherein the first sense transistor has a greater on-resistance than the first drive transistor.

## Claims

1. A method of determining a resistance of a first drive transistor in a drive system for operating a motor, the drive system comprising a first drive transistor, a first sense transistor, and a second drive transistor, wherein the first sense transistor is arranged in parallel with the first drive transistor, each transistor comprising a control terminal, a first channel terminal, and a second channel terminal,
the method comprising:
switching the first and second drive transistors to operate the motor using an operating current, wherein current is configured to flow between the first and second channel terminals of each drive transistor in an on-state such that the operating current flows between motor coils of the motor and a reference node, and wherein the reference node is shared by each of the transistors; and
operating the first sense transistor to determine the on-state resistance of the first drive transistor, wherein the operating current flows between motor coils of the motor and the reference node through the first sense transistor.

2. The method of claim 1, wherein the drive system further comprises a second sense transistor corresponding to the second drive transistors and arranged in parallel with the second drive transistor, the method further comprising: operating the second sense transistor to determine the on-state resistance of the first drive transistor, wherein the operating current flows between motor coils of the motor and the reference node through the second sense transistor.

3. The method of any one of claims 1 or 2, wherein the on-state resistance of the first drive transistor is determined based on determining a current flowing through each of the first and second sense transistors.

4. The method of any preceding claim, wherein the method further comprises: determining the motor current based on a measured voltage and the on-resistance of the first drive transistor.

5. The method of any preceding claim, wherein operating the first and second sense transistors comprises: operating the first sense transistor in an on-state when the first drive transistor is commanded to operate in an on-state, and optionally,
wherein operating the first and second sense transistors comprises: operating the first sense transistor in an on-state when the second drive transistor is commanded to operate in the on-state.

6. The method of claim 5, when the first sense transistor is operated in the on-state and the first drive transistor is commanded to operate in the on-state:
operating the first drive transistor in an off-state for a first time period;
measuring a current flowing through the first sense transistor during the first time period; and,
measuring a voltage difference between the first and second channel terminals of the second drive transistor during the first time period.

7. The method of claim 5, further comprising:
during a first time period, operating the first drive transistor in the on-state; and, measuring a first voltage difference between the first and second channel terminals of the first drive transistor;
during a second time period, operating the first drive transistor in the on-state; measuring a second voltage difference between the first and second channel terminals of the first drive transistor; and, operating the first sense transistor in on-state during the second time period;
during a third time period, operating the first drive transistor in the on-state; and, measuring a third voltage difference between the first and second channel terminals of the first drive transistor, wherein determining the on-state resistance of the first drive transistor is based on the measured first, second, and third voltage differences, and optionally, further comprising:
during the first time period, operating the first sense transistor in the off-state, wherein the first sense transistor is operated in the on-state during the second time period;
during the third time period, operating the first sense transistor in the off-state.

8. The method of claim 7, further comprising: operating each of the first and second drive transistors in the on-state continuously during the first and second time periods.

9. The method of any preceding claim, wherein operating the first and second sense transistors comprises: operating the second sense transistor in an on-state when the second drive transistor is commanded to operate in an on-state, and optionally,
wherein the second sense transistor is operated in an on-state when the first and second drive transistors are commanded to operate in the on-state.

10. The method of claim 9, when the second sense transistor is operated in the on-state and the second drive transistor is commanded to operate in the on-state:
operating the second drive transistor in an off-state for a second time period;
measuring a current flowing through the second sense transistor during the second time period; and,
measuring a voltage difference between the first and second channel terminals of the first drive transistor during the second time period.

11. The method of claim 9, during a fourth time period, operating the second drive transistor in the on-state; and, measuring the fourth voltage difference between the first and second channel terminals of the second drive transistor;
during a fifth time period, operating the second drive transistor in the on-state; and, measuring a fifth voltage difference between the first and second channel terminals of the second drive transistor;
during a sixth time period, operating the second drive transistor in the on-state; and,
measuring a sixth voltage difference between the first and second channel terminals of the second drive transistor, wherein determining the on-state resistance of the first drive transistor is based on the measured fourth, fifth, and sixth voltage differences, and optionally, further comprising:
during the fourth time period, operating the second sense transistor in the off-state, wherein the second sense transistor is operated in the on-state during the fifth time period;
during the sixth time period, operating the second sense transistor in the off-state.

12. The method of any preceding claim, further comprising: comparing a voltage difference between the first and second channel terminals of the first drive transistor to a first sense transistor limitation threshold, wherein when the voltage difference is less than the first sense transistor limitation threshold, operating the first sense transistor in the on-state, and optionally,
wherein when the voltage difference is less than the first sense transistor limitation threshold, operating the first drive transistor in the off-state.

13. A driver circuit comprising:
first and second drive transistors and corresponding first and second sense transistors, wherein each sense transistor is arranged in parallel with a respective one of the drive transistors, the first and second drive transistors arranged to drive a load, each transistor comprising a control terminal, a first channel terminal, and a second channel terminal, wherein current is configured to flow between the channel terminals of each drive transistor in an on-state such that an operating current flows between motor coils of the motor and a reference node, wherein the reference node is shared by each of the transistors; and
one or more processors configured to perform the method of any one of claims 1 to 12.

14. The driver circuit of claim 13, further comprising a logic circuit configured to:
receive a command signal configured to operate the first drive transistor, wherein the command signal is generated by the one or more processors for PWM control of the motor;
receive an override signal based on the on-state and/or off-state of each of the drive transistors; and,
operate the first drive transistor based on the command signal and the override signal.

15. The driver circuit of any one of claims 13 or 14, wherein the one or more processors comprise a gate driver integrated circuit, and the gate driver integrated circuit comprises the sense transistors, wherein the drive transistors are external to the one or more processors.
